# EUROPEAN PATENT APPLICATION

(11) **EP 1 282 167 A2**
(43) Date of publication of application: **05.02.2003**
(21) Application number: 02255278.0
(22) Date of filing: 29.07.2002
(51) Int. Cl.: H01L 23/40

(54) **Fastener retainer assembly**

(30) Priority: 31.07.2001 US 920424
(71) Applicant: Hewlett-Packard Company, Palo Alto, CA 94304 (US)
(72) Inventor: Hegde, Shankar, Annassandrapalya, Bangalore 560017 (IN)
(74) Representative: Tollett, Ian

(57) **Abstract**

A retainer assembly **10** for retaining a fastener **60** that includes a shank **63** having a recessed portion **65** therein is disclosed. The retainer assembly **10** includes an inner wall **15** that is inset from and outer wall **13** and is symmetrically positioned about an axis **Y-Y** defining a chamber **20** through the retainer body **12.** The chamber **20** includes opposed entrance **17** and exit **19** apertures. The inside wall **15** includes a first inside diameter **D**_{**1**} that extends from the entrance aperture **17** in a direction along the axis **Y-Y** and narrowing to a second inside diameter **D**_{**2**} at a slip-over profile **21**, and the inner wall **15** narrowing again to a third inside diameter **D**_{**3**} at an annular ring **23** that extends to the exit aperture **19.** The fastener **60** is inserted through the entrance aperture **17** until the shank **63** engages and then slips over the slip-over profile **21** and through the annular ring **23** so that the recessed portion **65** of the shank **63** is captured within the annular ring **23**.

## Description

The present invention relates generally to a fastener retainer assembly that is adaptable to a number of applications that use fasteners. More specifically, the present invention relates to a fastener retainer assembly that can retain a fastener and optionally a spring to a base plate of a cooling device such as a heat sink.

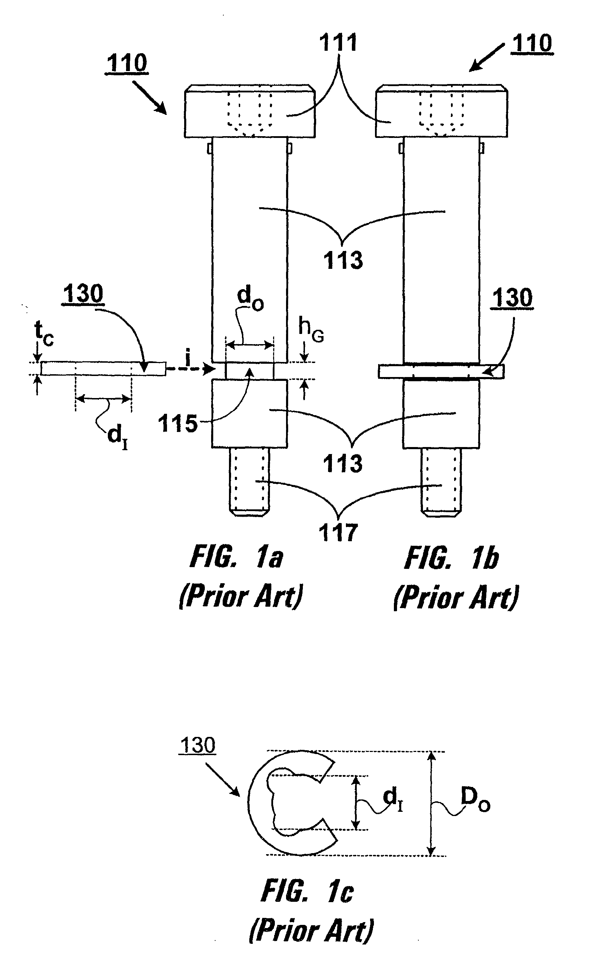

Current methods for retaining a fastener in a through hole includes the use of a circlip. The circlip is a c-shape fastener that fits within a groove machined into a shank of the fastener, such as a screw for example. In **FIGS. 1a** through **1c**, one example of a prior fastener **110** and a prior circlip **130** are illustrated. The fastener **110** includes a head portion **111** for receiving a tool used to screw or unscrew the fastener **110**, a shank **113**, a groove **115** formed in the shank **113**, and a threaded portion **117** for insertion into a hole having screw threads therein. Typically, the groove **115** is machined with a high tolerance into the shank **113**. Similarly the circlip **130** is also machined with a high tolerance so that a thickness **t**_{**C**} of the circlip **130** fits within a height **h**_{**G**} of the groove **115** so that the circlip **130** can be inserted (dashed arrow **i)** into the groove **115.** Additionally, an inside diameter **d**_{**I**} of the circlip **130** must be precision machined to fit over an outside diameter **d**_{**O**} (see **FIG. 1c**) of the groove **115.** When the fastener **110** is inserted through a hole (not shown) adapted to receive the fastener **110,** the circlip **130** is inserted (see **FIG. 1b**) into the groove **115** so that the fastener **110** is retained in the hole because an outside diameter **D**_{**O**} of the circlip **130** is wider than an inside diameter of the hole the fastener **110** was inserted in; therefore, the fastener **110** cannot be pulled out of the hole unless the circlip **130** is removed.

There are some disadvantages to using a circlip such as the prior circlip **130** as a fastener retainer. First, because both the fastener **110** and the circlip **130** are parts that are precision machined to high tolerances and specifications, those parts cost more than if they were not precision machined. Second, to insert or remove the circlip **130** requires special tools. Therefore, manufacturing time and costs to assemble or disassemble the circlip **130** and fastener **110** are higher. Third, the circlip**130** is a specialized fastener component that is usually procured from an external supplier and adequate quantities must be held in inventory to ensure a ready supply. Accordingly, there is an inventory cost associated with maintaining that ready supply. Fourth, because of the high manufacturing tolerances of the circlip **130** and the fastener **110**, a need to change the dimensions of the fastener **110** requires a change in the dimensions of the circlip **130**. Therefore, those high tolerances preclude fastener design changes that may be necessary.

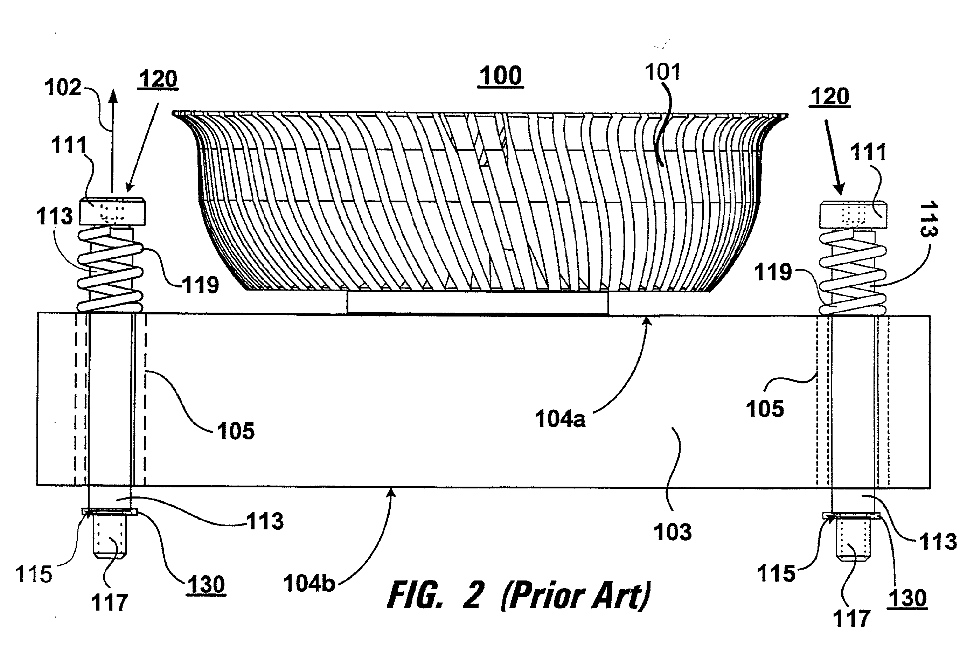

A prior use for a fastener and a circlip to retain the fastener is illustrated in **FIG. 2** where a heat sink **100** having a plurality of cooling fins **101** is connected with a base plate **103** having an upper surface **104a** and a lower surface **104b.** The base plate **103** includes through holes **105** extending between the upper and lower surfaces (**104a, 104b**). Fasteners **120** are inserted into the through holes **105.** The fasteners **120** include the aforementioned head portion **111**, the shank **113,** the groove **115,** and the threaded portion **117.** Additionally, the fasteners **120** are retained in the through holes **105** by circlips **130**. The circlips **130** prevent removal of the fasteners **120** from the through holes in a direction indicated by arrow **102**. Optionally, the fasteners **120** can include springs **119** that are fitted over their respective shanks **113** prior to insertion in the through holes **105**. The clips **130** retain the fasteners **120** and the springs **119** to the base plate **103**.

Typically, a component to be cooled (not shown), such as a microprocessor, is in contact with the lower surface **104b** and waste heat generated by operation of the component is thermally transferred into the heat sink **100** were the heat is dissipated by a fan (not shown) that forces an air flow through the fins **101**. The component is usually mounted to a PC board (not shown) and the threaded portion **117** of the fasteners **120** are screwed into threaded holes provided on the PC board so that the base plate **103** is mounted to the PC board and in contact with the component. As the fasteners **120** are screwed into the PC board, the springs **119** compress and urge the lower surface into snug contact with the component thereby lowering thermal resistance between the component and the base plate **103**.

As mentioned previously, one disadvantage to using circlips **130** to retain the fasteners **120** and springs **119** is that specialized tools are required to insert or remove the circlips **130**. For instance, specialized circlip pliers are needed to insert or remove the circlips **130** and those pliers increase assembly/disassembly time.

Another disadvantage is that after the base plate **103** is mounted to the PC board, an electrical short can occur if the circlips **130** come in contact with electrical traces on the PC board because the circlips **130** are typically made from an electrically conductive material, such as a metal, for example. In some applications, keep out zones are defined around an area to be occupied by the circlips **130** so that the electrical traces will be routed around the keep out zones to prevent the electrical traces from shorting with the circlips **130**. In a densely routed PC board, those keep out zones can complicate routing of the electrical traces.

Finally, in some applications, the fasteners **120**, the springs **119,** and the circlips **130** used for connecting the base plate **103**, are shipped separately to an end user, such as a customer, for example. The customer must then assemble the fasteners **120**, the springs **119**, and the circlips **130** to the base plate **103**. The disadvantages of having the customer perform those tasks include increased assembly time and customer frustration that can arise due to difficulty in aligning the fasteners.

Consequently, there exists a need for a fastener retainer that does not require specialized tools to install or remove and that does not require the fastener or the retainer to be manufactured to high tolerances and specifications. Additionally, there is a need for a fastener retainer that will not cause an electrical short between electrical traces that come into contact with the fastener retainer. There also exists a need for a fastener retainer that reduces assembly time. There is a need for a fastener retainer that allows for flexibility in fastener selection so that design changes can be accommodated without redesigning the fastener retainer. Finally, there is a need for a fastener retainer that can be manufactured at low cost and has a low inventory cost.

The present invention addresses the aforementioned problems. The retainer
assembly of the present invention does not require special tools for installation or removal thereby reducing assembly time. Moreover, the retainer assembly of the present invention can be made from a non-conductive plastic material that will not cause an electrical short circuit between electrical traces that come into contact with the retainer assembly. The plastic material allows for a low manufacturing and inventory costs. Additionally, the need for fasteners manufactured to high tolerances and specifications are eliminated by the retainer assembly because slight variations in fastener tolerances will not prevent retention of the fastener in the retainer assembly. Consequently, the retainer assembly allows for flexibility in fastener selection and can accommodate design changes. The retainer assembly allows for the fasteners and springs used with the base plate of a heat sink to be preassembled on the base plate prior to shipment to an end user. As a result, the end user is not burdened with additional assembly time and the frustrations that can result from trying to properly align all the fasteners.

Broadly, the present invention is embodied in a retainer assembly for retaining a fastener having a recessed portion formed in a shank of the fastener. A retainer assembly according to the present invention includes a retainer body having an outer wall with an outside diameter and an inner wall inset from the outer wall. The inner wall is symmetrically positioned about an axis and defines a chamber that extends through the retainer body. The chamber has opposed entrance and exit apertures and the inner wall includes a first inside diameter that extends inward of the entrance aperture in a direction along the axis. The first inside diameter then narrows to a second inside diameter at a slip-over profile. The second inside diameter then narrows to a third inside diameter at an annular ring that extends to the exit aperture. The fastener is inserted through the entrance aperture until the shank engages and then slips over the slip over profile and through the annular ring so that the recessed portion of the shank is captured within the annular ring and the fastener is retained in the chamber of the retainer assembly.

The retainer body can be inserted into a hole formed in a surface and having an inside diameter that is greater than the outside diameter of the outer wall. After insertion, the fastener can be inserted into the retainer assembly as described above and is retained in the retainer assembly when the recessed portion is captured within the annular ring. The portion of the shank that slipped over the slip-over profile will protrude from the exit aperture and if that portion included threads, then the fastener can be screwed into a threaded hole or the like. No special tools are required to insert the fastener into the retainer assembly.

In one embodiment of the present invention the retainer assembly includes a flange that is connected with the outer wall and extends outward of the outer wall. The flange prevents complete insertion of the retainer body into a bore (i.e. a hole).

In another embodiment of the present invention, the outer wall includes two or more ribs that are connected with the outer wall and extend outward of the outer wall. The ribs deform (i.e. they crush or partially collapse) when the retainer body is inserted into a bore. The ribs assist in centering the retainer body in the bore.

In yet another embodiment of the present invention, the retainer assembly includes at least two retainer bodies and a spanner connects the bodies and spatially positions the retainer bodies relative to each other.

In one embodiment of the present invention, the retainer body is made from an electrically non-conductive material.

Other aspects and advantages of the present invention will become apparent from the following detailed description, taken in conjunction with the accompanying drawings, illustrating by way of example a number of preferred embodiments of the present invention.

**FIGS. 1a** through **1c** depict a prior fastener and a circlip for retaining the fastener.

**FIG. 2** is a cross-sectional view of a prior fastener and spring retained by a circlip in a base plate of a heat sink.

**FIGS. 3a** through **3c** are cross-sectional, top, and bottom views of a retainer assembly according to the present invention.

**FIGS. 4a** through **4c** are cross-sectional, top, and bottom views of a retainer assembly including a flange and ribs according to the present invention.

**FIG. 5** is a cross-sectional view depicting in greater detail of a portion of the retainer assembly of **FIG. 4a** below line **A-A.**

**FIG. 6** is a cross-sectional view of the retainer assembly of **FIG. 4a** inserted in a bore according to the present invention.

**FIG. 7** is a cross-sectional view of a plurality of a retainer assembly including a plurality of retainer bodies connected to each other by a spanner according to the present invention.

**FIGS. 8a** and **8c** are top, bottom, and profile views respectively of the retainer assembly of **FIG. 7**.

**FIGS. 9a** and **9b** are schematic views of an example of a fastener and a spring respectively that can be retained by a retainer assembly according to the present invention.

**FIG. 10** is a cross-sectional view depicting insertion of a fastener into a retainer assembly according to the present invention.

**FIG. 11** is a cross-sectional view depicting a fastener that has been fully inserted and captured within a retainer assembly according to the present invention.

**FIG. 12** is a cross-sectional view depicting insertion of a plurality of fasteners into retainer bodies connected with a spanner according to the present invention.

**FIG. 13** is a top profile view illustrating a retainer assembly and fasteners prior to insertion into a base plate according to the present invention.

**FIG. 14** is a bottom profile view illustrating the base plate of **FIG. 13** after insertion of the retainer assembly and fasteners according to the present invention.

**FIG. 15** is an illustration of a heat sink and fan mounted to the base plate of **FIG. 14**.

**FIG. 16** is a schematic view of a base plate adapted to receive a retainer assembly according to the present invention.

In the following detailed description and in the several figures of the drawings, like elements are identified with like reference numerals.

As shown in the drawings for purpose of illustration, the present invention is embodied in a retainer assembly for retaining a fastener that includes a shank having a recessed portion therein. The retainer assembly includes at least one retainer body having an outer wall with an outer diameter and an inner wall that is inset from the outer wall and is symmetrically positioned about an axis thereby defining a chamber through the retainer body. The chamber includes an entrance aperture that is positioned opposite an exit aperture. The inside wall includes a first inside diameter that extends from the entrance aperture in a direction along the axis and narrowing to a second inside diameter at a slip-over profile, and the inner wall narrowing again to a third inside diameter at an annular ring that extends to the exit aperture. Therefore, the inner wall includes in order of decreasing inside diameter, the first, second, and third inside diameters. The fastener is inserted through the entrance aperture until the shank engages and then slips over the slip-over profile and through the annular ring so that the recessed portion of the shank is captured within the annular ring.

The retainer body is made from a material that can deform slightly at the slip-over profile in response to the shank passing through the chamber. The shank has an outside diameter that is greater than the third inside diameter at the annular ring but is only slightly greater than the second inside diameter at the slip over profile. As a result, the shank can slip past the slip-over profile and through the annular ring as the retainer body deforms, but after the shank has passed through the annular ring and out of the exit aperture, the recessed portion is captured within the annular ring because the recessed portion has an outside diameter that is less than the third inside diameter. Due to the larger outside diameter of the shank, the retainer body will not deform to allow the shank to pulled back through the annular ring.

The retainer assembly can be made from an electrically non-conductive material so that the retainer assembly will not cause a short circuit if it comes into contact with electrically conductive traces.

The use of plastic for the retainer assembly also allows for low manufacturing and inventory costs and allows for variations in fastener dimensions without having to resort to the use of a different retainer assembly for minor variations in fastener dimensions.

A fastener can be inserted and removed from the retainer assembly without the need for special tools and insertion and removal can be done quickly thereby reducing assembly and disassembly time.

The retainer assembly positions an inserted fastener on axis so that the fastener is substantially in alignment with a threaded hole or the like for receiving a threaded portion of the fastener.

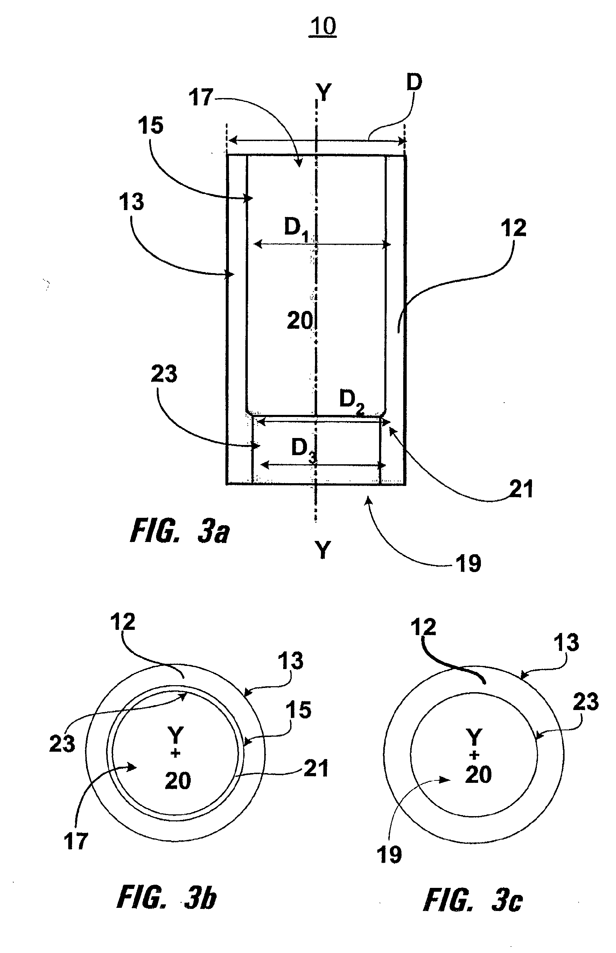

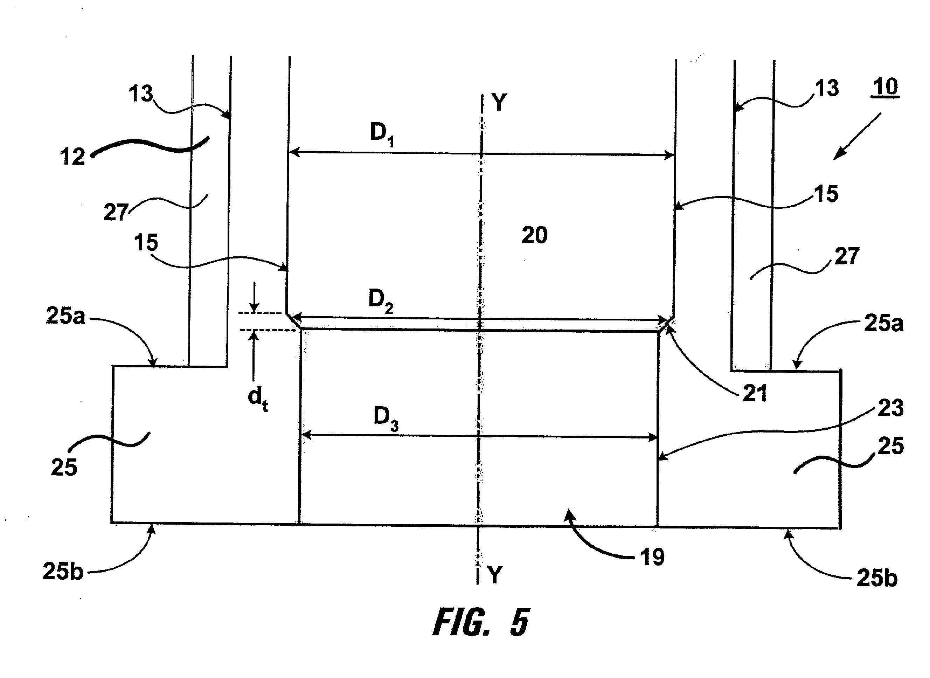

In **FIG. 3a**, a retainer assembly **10** includes a retainer body **12** that includes an outer wall **13** having an outside diameter **D** and an inner wall **15** that is inset from the outer wall **13.** The inner wall **15** is symmetrically positioned about an axis **Y-Y** and defines a chamber **20** having an entrance aperture **17** and an exit aperture **19**. Along the axis **Y-Y** in a direction from the entrance aperture**17** to the exit aperture **19,** the inner wall **15** narrows in inside diameter as follows. The inner wall **15** includes a first inside diameter **D**_{**1**} that extends from the entrance aperture **17** and then narrows to a second inside diameter **D2** at a slip-over profile **21** and then narrows again to a third inside diameter **D**_{**3**} at an annular ring **23** (**D**_{**3**} < **D**_{**2**} < **D**_{**1**}). The annular ring **23** extends to the exit aperture **19.** The slip-over profile **21** can have an sloped profile (see **FIG. 5**) or a concave arcuate profile. The sloped or arcuate profile allows for a gradual transition over a short distance **d**_{**t**} from the first inside diameter **D**_{**1**} to the third inside diameter **D**_{**3**}. Essentially, the second inside diameter **D2** at the slip-over profile **21** is not a substantially constant inside diameter due to the profile of the slip-over profile **21** so that the second inside diameter **D**_{**2**} decreases slightly in inside diameter along a surface of the profile until it blends with the third inside diameter **D**_{**3**} at the annular ring **23.** Preferably, the slip-over profile **21** has a sloped profile.

**FIGS. 3b** and **3c** are top and bottom views respectively of the retainer assembly **10**. **FIG. 3b,** illustrates a view that is into the chamber **20** from the entrance aperture **17** and **FIG. 3c** illustrates a view that is into the chamber **20** from the exit aperture **19.** It should be noted that in **FIGS. 3b** and **3c,** the inside diameter of the entrance aperture **17** is greater than the inside diameter of the exit aperture **19**.

The retainer assembly **10** can be made from a variety of materials including metals, elastomers, rubber, and plastics. The choice of material will be application dependent. For instance, for electrical applications it may be desirable to use plastic or rubber because plastic and rubber are generally electrically non-conductive materials. In one embodiment of the present invention, the retainer body **12** is made from an electrically non-conductive material. The electrically non-conductive material can include but is not limited to a glass filled polycarbonate. An exemplary electrically non-conductive material is 30% glass filled polycarbonate.

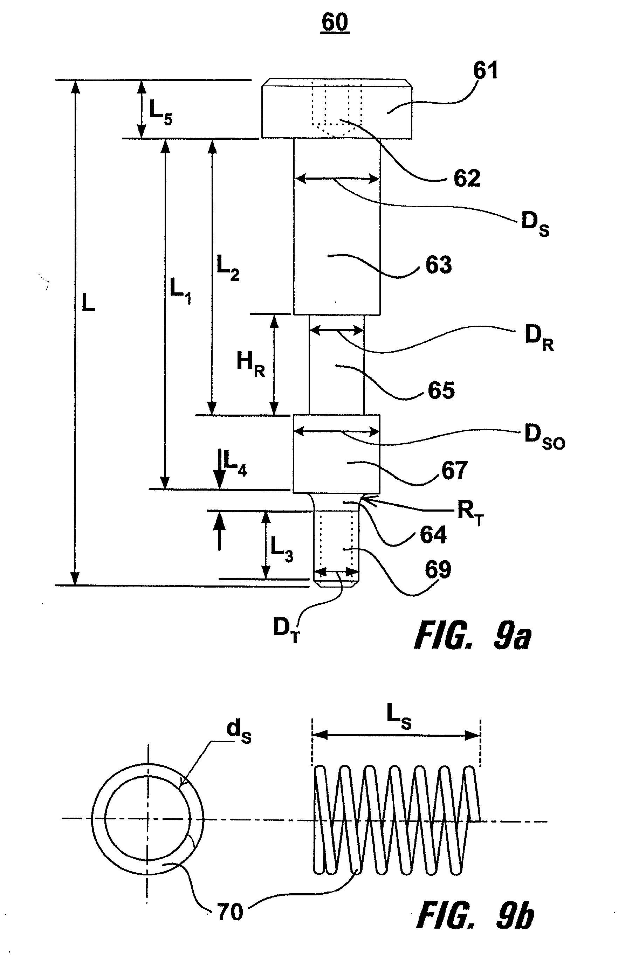

In **FIG. 9a,** a fastener **60** includes a head **61** having a slot **62** adapted to be driven by a tool such as a screw driver, a hex driver, or the like. The fastener **60** further includes a shank **63** having an outside diameter **D**_{**S'**} a recessed portion **65** having an outside diameter **D**_{**R'**} a shank **67** having an outside diameter **D**_{**SO'**} and a threaded portion **69** having an outside diameter **D**_{**T**}. The outside diameters (**D**_{**S'**} **D**_{**SO**}) of the shanks (**63, 67**) can be identical (**D**_{**S**} = **D**_{**SO**}) or the outside diameter **D**_{**SO**} of shank **67** can be less than the outside diameter **D**_{**S**} of the shank 63 (**D**_{**SO**} < **D**_{**S**}). The outside diameter **D**_{**T**} of the threaded portion **69** is less than the outside diameter **D**_{**SO**} of shank **67** (**D**_{**T**} < **D**_{**SO**}).

In **FIG. 9b,** a spring **70** that can optionally be used in conjunction with the fastener **60** and the retainer assembly **10** can have an inside diameter **d**_{**s**} that is larger than the outside diameters of either one of the shanks (**63, 67**). That is, the inside diameter **d**_{**s**} **> D**_{**s**} and **d**_{**s**} **> D**_{**SO**} so that the fastener **60** can be inserted into the spring **70.**

When the fastener **60** is inserted through the entrance aperture **17** and into the chamber **20**, the shank **67** engages the slip-over profile **21** and slips over the slip-over profile and through the annular ring **23** and out the exit aperture **19**. The threaded portion **69** easily passes through the entirety of the chamber **20** and out the exit aperture **19** because its outside diameter **D**_{**T**} is less than the third inside diameter **D**_{**3**}. However, the recessed portion **65** is captured within the annular ring **23** because the outside diameter **D**_{**S**} of the shank **63** cannot pass through the slip-over profile **21** and the outside diameter **D**_{**SO**} of shank **67** is greater than the third inside diameter **D**_{**3**} of the annular ring **23** so the shank **67** cannot reenter the annular ring **23** through the exit aperture **19.**

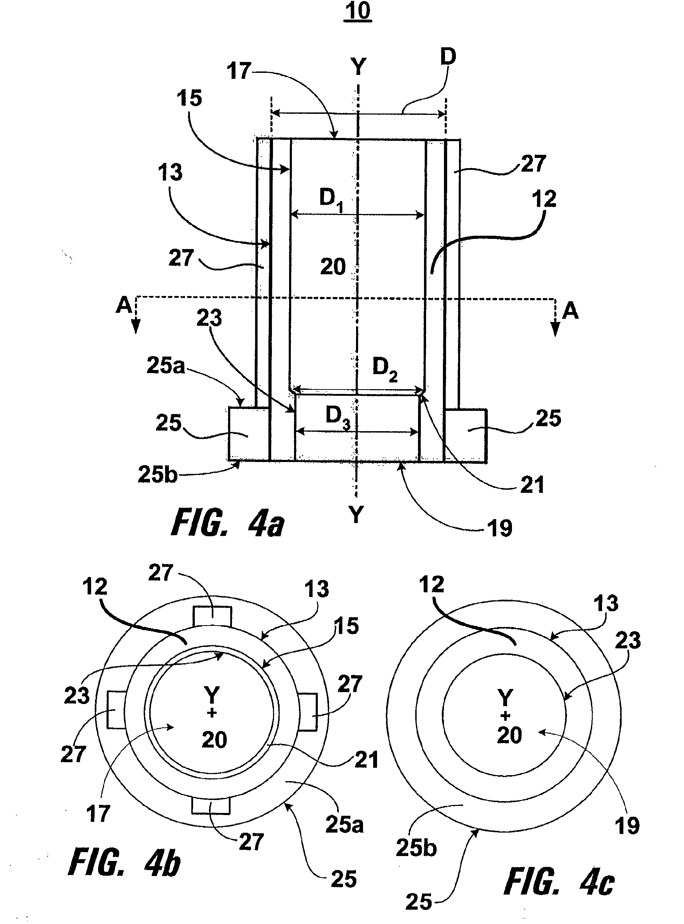

In one embodiment of the present invention as illustrated in **FIGS. 4a** through **4c** and **FIG. 5**, the retainer assembly **10** includes a flange **25** connected with the outer wall **13** and extending outward of the outer wall **13**. The flange **25** prevents complete insertion of the retainer body **12** into a bore (i.e. a hole) having a sufficient inside diameter to receive the retainer body **12**. The flange **25** includes an upper surface **25a** and a lower surface **25b**.

In another embodiment of the present invention, also illustrated in **FIGS. 4a** through **4c** and **FIG. 5,** the retainer assembly **10** includes a plurality of ribs **27** (four are shown) that are connected with the outer wall **13** and extend outward of the outer wall **13.** The ribs **27** are designed to deform (i.e. they collapse/crush) upon insertion of the retainer body **12** into a bore a sufficient inside diameter to receive the retainer body **12**. The ribs **27** also provide a tight fit between the bore and the retainer body **12** so that the retainer body **12** is retained (i.e is held) in the bore. Additionally, the ribs **27** operate to center the retainer body **12** within the bore. Preferably, the ribs **27** are equidistantly spaced apart from one another as illustrated in **FIG. 4b**. The ribs **27** can also have an orientation that is colinear (see **FIGS. 4a** and **4b**) with the axis **Y-Y**.

**FIG. 5** is an enlarged view of a section of the retainer assembly **10** of **FIG. 4a** taken along line **A-A.** In **FIG. 5**, the gradually decreasing inside diameter (**D**_{**3**} < **D**_{**2**} < **D**_{**1**}) of the chamber **20** is shown in greater detail and the sloped profile of the slip-over profile **21** illustrates that the second inside **D**_{**2**} varies in inside diameter along a surface of that profile as **D**_{**2**} narrows to a point where it blends with the third inside **D**_{**3**}.

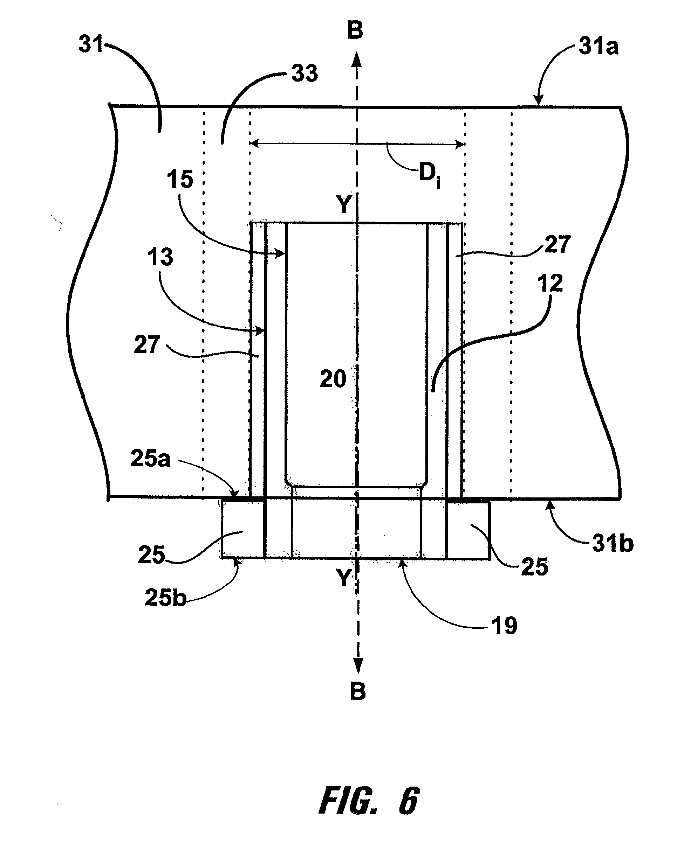

Turning now to **FIG. 6,** wherein, a object **31** has a through bore **33** (i.e. a through hole) formed therein and the retainer body **12** is inserted into the bore 33 with the upper surface **25a** of the flange **25** preventing complete insertion of the retainer body **12** into the bore **33.** The bore **33** has an inside diameter **D**_{**i**} sufficient to allow insertion of the retainer body **12.** A sufficient diameter includes one in which the total diameter of the retainer body **12** including the ribs **27** is greater than the inside diameter **D**_{**i**} because the ribs **27** can collapse upon insertion into the bore **33.** As was mentioned above, the ribs **27** aid in centering the retainer body **12** in the bore **33** so that the axis **Y-Y** is aligned with a bore central axis **B-B**. Another advantage to using the ribs **27** is that upon insertion into the bore **33,** the ribs crush and retain the retainer body 12 in the bore 33.

The object **31** can be a surface or it can be a base plate for a heat sink. The retainer assembly **10** of the present invention can be used in a wide variety of applications in which it is necessary to retain a fastener. Accordingly, the retainer assembly **10** of the present invention is not to be construed as being limited to use with heat sinks.

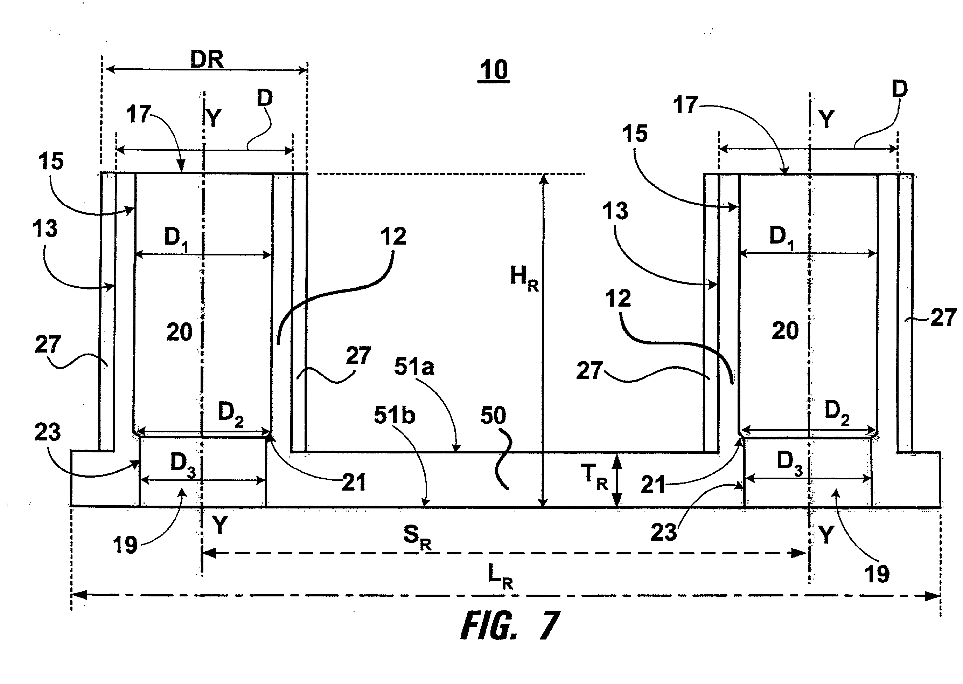

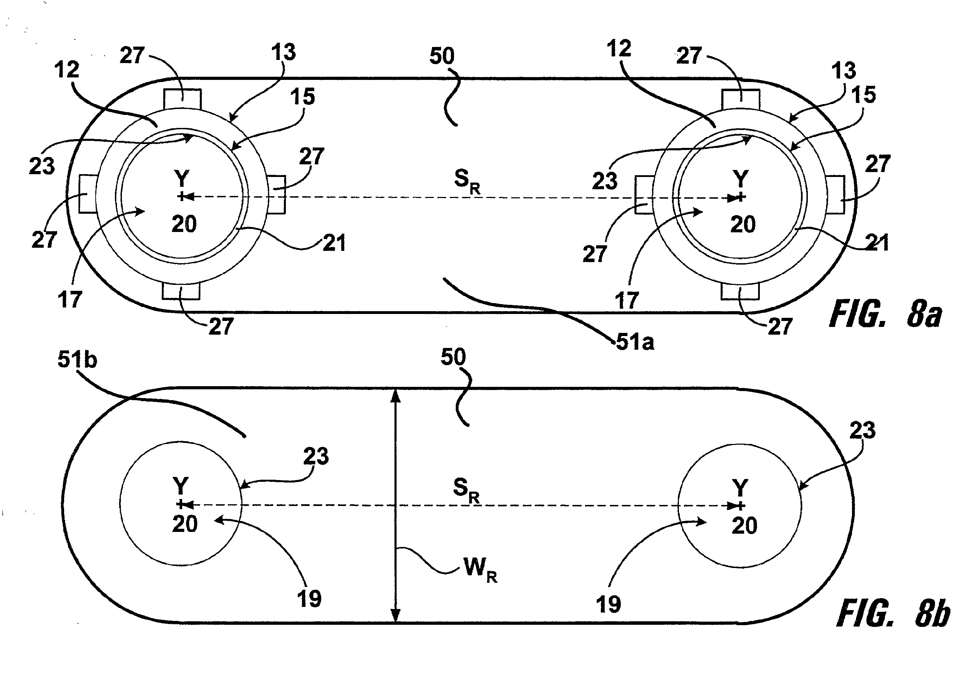

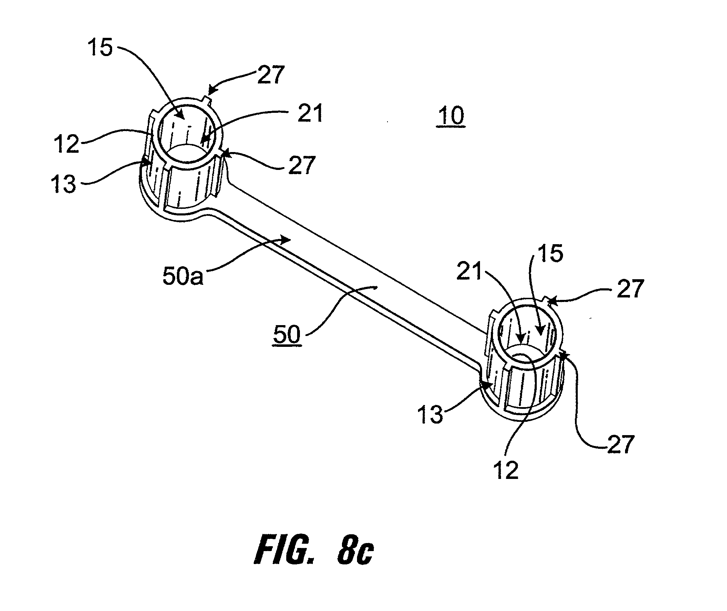

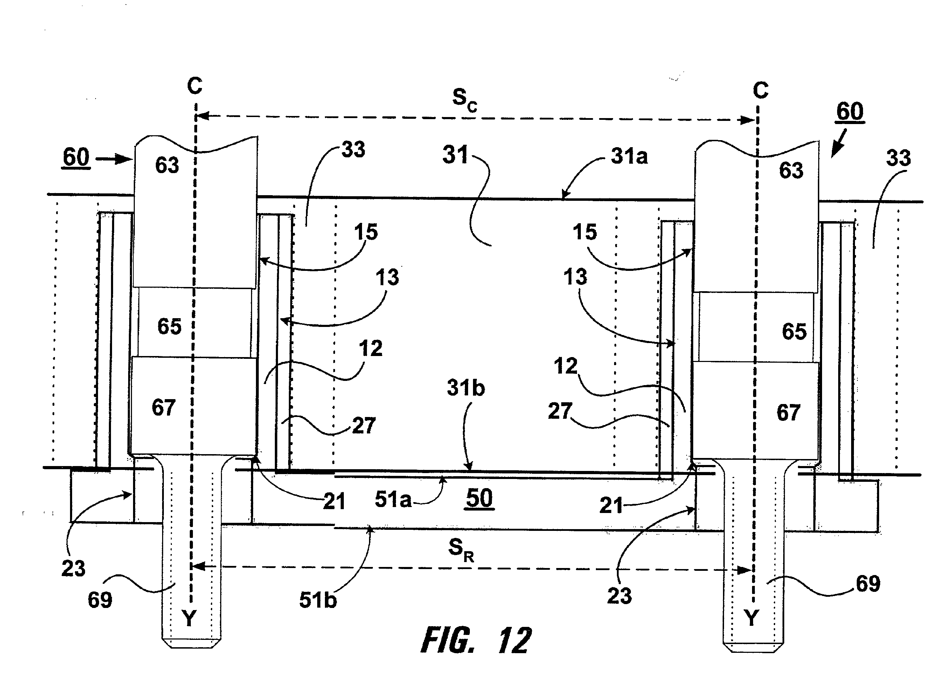

In one embodiment of the present invention as illustrated in **FIGS. 7**, and **8a** through **8c,** the retainer assembly **10** includes a spanner **50** that is connected with at least two retainer bodies **12.** The spanner **50** includes an upper surface **51a** and a lower surface **51b**. The upper surface **51a** can serve a purpose similar to that of the aforementioned flange **25** and its upper surface **25a** by preventing complete insertion of the retainer bodies **12** into a bore (see **FIG. 12**). The spanner **50** spatially positions the retainer bodies **12** relative to each other. For instance, the spanner **50** can establish a predetermined distance **S**_{**R**} between the axes **Y-Y** of the retainer bodies **12** as illustrated in **FIGS. 7, 8a,** and **8b.** The predetermined distance **S**_{**R**} can be selected to substantially match hole centers in bores the retainer bodies **12** will be inserted in.

Although **FIGS. 7**, and **8a** through **8c** illustrate only two retainer bodies **12**, the spanner **50** can connect a plurality of the retainer bodies **12**. The retainer bodies **12** need not be positioned in a substantially linear arrangement with each other on the spanner **50** and the retainer bodies **12** need not be positioned in a substantially planar relationship with each other on the spanner **50** as illustrated in **FIGS. 7**, and **8a** through **8c.** For instance, the spanner **50** can spatially position one of the retainer bodies **12** on plane that is higher or lower than that of other retainer bodies **12** that are also connected with the spanner **50.** That arrangement can be useful for insertion of the retainer bodies **12** into bores that lie different planes. Preferably, spanner **50** positions the retainer bodies **12** so that they are in a substantially planar orientation with each other. The retainer bodies **12** can include the ribs **27** as described above.

Preferably, the spanner **50** and the retainer bodies **12** are made from the same material and that material can be the same as the material as set forth above. For electrical applications, the preferred material is a plastic such as the aforementioned electrically non-conductive materials such as glass filled polycarbonate and 30% glass filled polycarbonate.

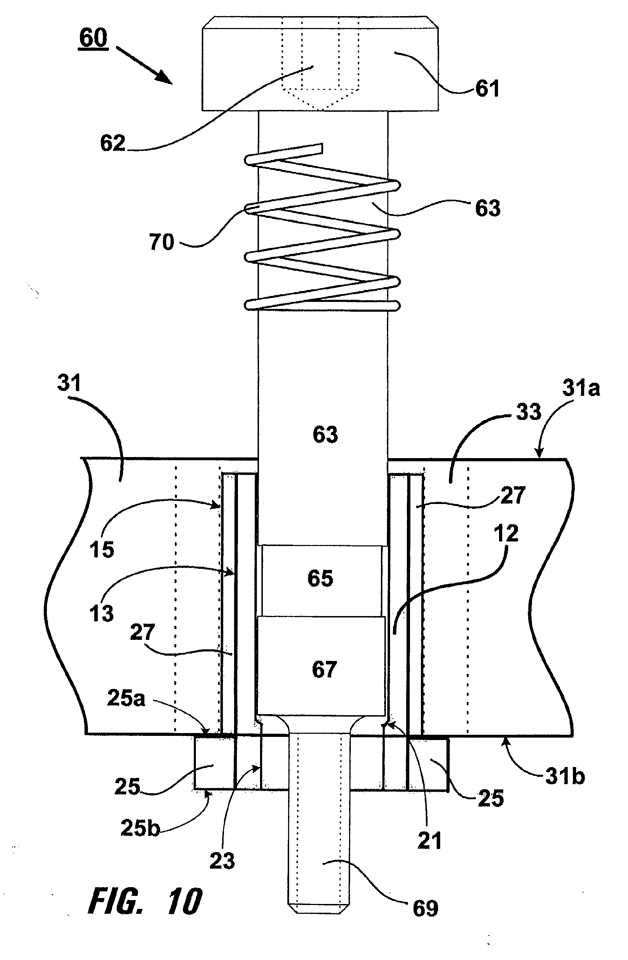

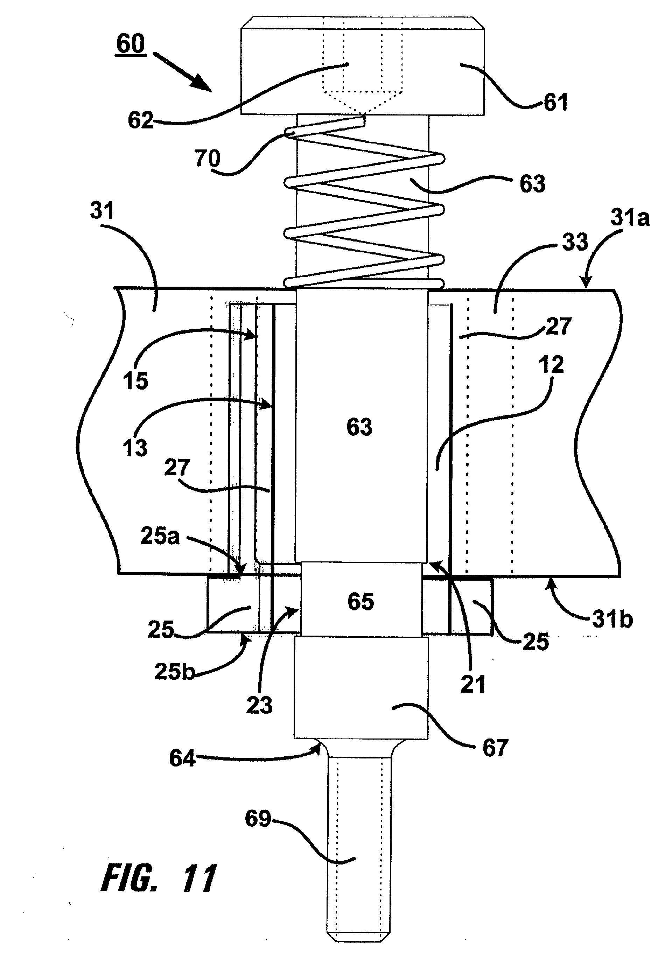

Now, for all the embodiments described herein, **FIGS. 10, 11,** and **12** illustrate the insertion and retention of the fastener **60** in the retainer assembly **10.** In **FIG. 10**, the fastener **60** is depicted with the shank **67** already inserted in the chamber **20** and positioned proximate the slip-over profile **21**. The threaded portion **69** is substantially outside the annular ring **23** due to the small outside diameter of the threaded portion **69** relative to the inside diameter **D**_{**3**} of the annular ring **23.** Prior to insertion of the fastener **60** into the chamber **20,** a spring **70** may be fitted over the shank **63**. The shank **67** is now urged into contact with the slip-over profile **21** so that the shank **67** slips past the slip-over profile **21** and into and through the annular ring **23** and out of the exit aperture **19** as depicted in **FIG. 11**. In **FIG. 11**, the outside diameter **D**_{**S**} of the shank **63** cannot slip past the slip-over profile **21.** Similarly, the outside diameter **D**_{**SO**} of shank **67** will not allow the shank **67** to slip past the annular ring **23.** As a result, the recessed portion is captured in the annular ring **23** and the fastener **60** is retained by the retainer assembly **10.**

Depending on the dimensions of the fastener **60** and the retainer assembly **10,** the spring **70** may be in a compressed state after insertion and retention of the fastener **60** in the retainer assembly **10**. On the other hand, the spring **70** may not be in a compressed state after insertion and retention.

In **FIG. 12**, the spanner **50** is used to position the retainer bodies **12** so that their respective axes **Y-Y** substantially align with bore hole centers **C-C** of bores **33** that are formed in the object **31.** For purposes of illustration only, the head portions **6**1 of the fasteners **60** have been omitted. The fasteners are depicted with their respective shanks **67** positioned proximate the slip-over profiles **21** of the retainer bodies **12**. After complete insertion and retention, the configuration of **FIG. 12** has the added benefit of maintaining the fasteners in alignment with the axis **Y-Y** so that the threaded portions **69** can be more easily aligned with threaded holes they are to be inserted in.

Therefore, the configuration illustrated in **FIG. 12** is ideal for retaining fastener in a base plate of a heat sink because there are usually four fasteners used for mounting the base plate to a mother board. If the fasteners are allowed to move freely as in the case when the prior circlips are used to retain the fasteners, then it will be difficult to simultaneously align all four fasteners with their respective threaded holes. In contrast, the retainer assembly **10** of the present invention sufficiently restricts movement of the fasteners **60** (i.e. they don't wobble) so that the threaded portions **69** can be aligned with their respective threaded holes on the mother board.

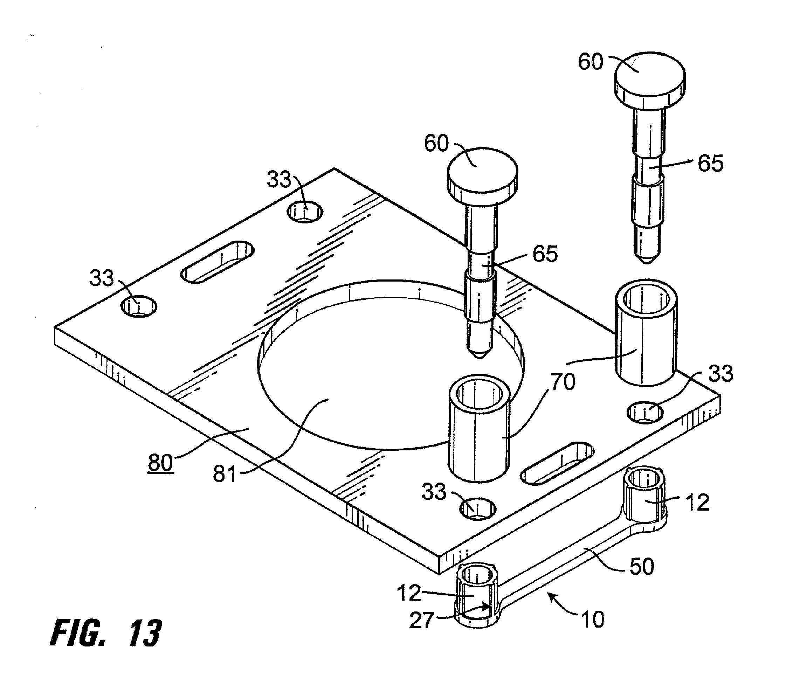

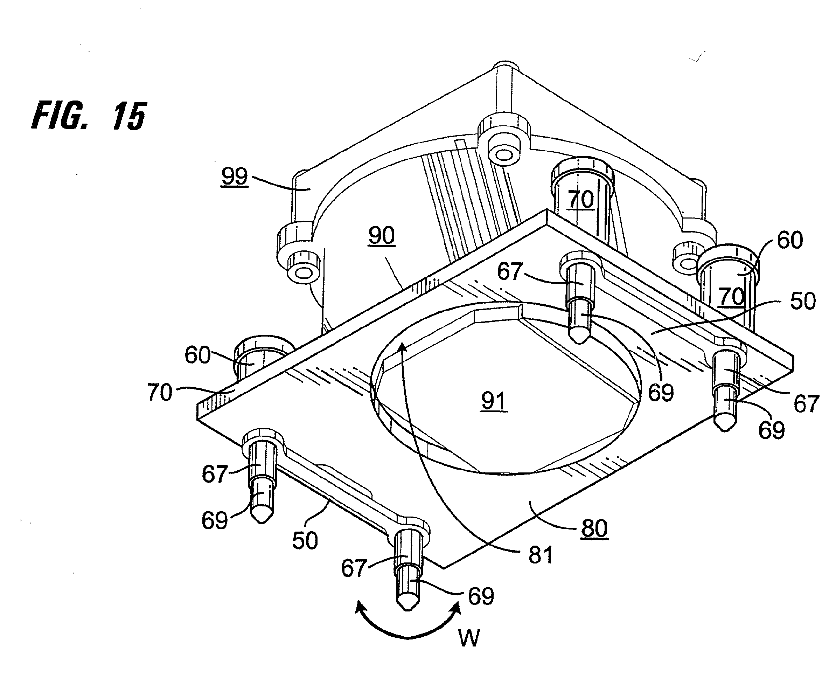

In **FIG. 13,** a base plate **80** having an aperture **81** therein for receiving a base portion of a heat sink (see reference numeral **91** in **FIG. 15**) includes several bores **33** through which the retainer assembly **10** with retainer bodies **12** connected with the spanner **50** prior to insertion into the bores **33.** As was mentioned above, the spanner **50** can position the retainer bodies **12** so that their respective axes **Y-Y** (not shown) are substantially aligned with a central axis **C-C** (see **FIG. 12**) of the bores **33**. The fasteners **60** and the springs **70** are positioned to be inserted through the bores **33** and into the chambers **20** of the retainer bodies **12**.

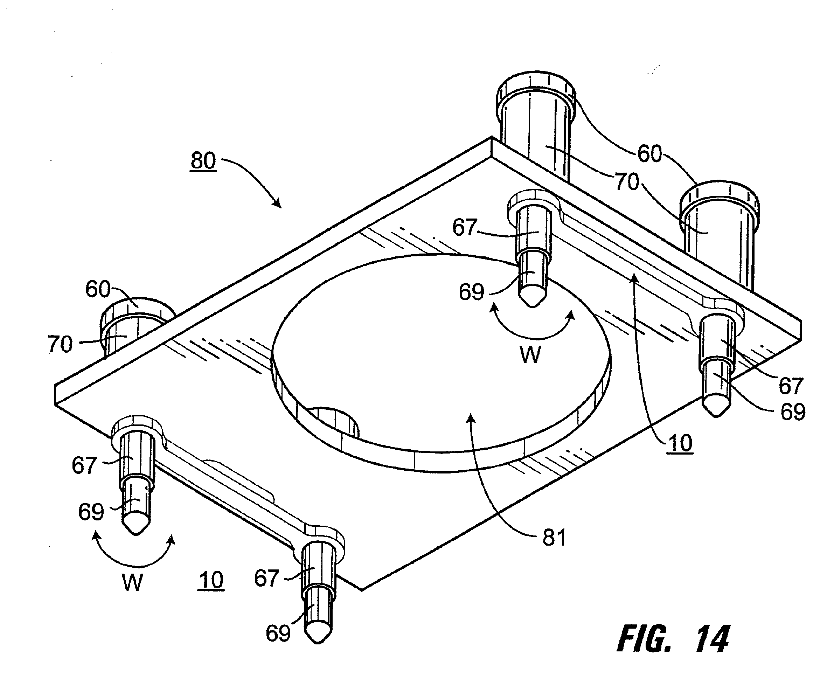

In **FIG. 14**, the retainer assemblies **10** have been inserted into the bores **33** by pressing them into contact with the bores **33** until the ribs **27** deform and the retainer bodies **12** slide into their respective bores **33**. The springs **70** are the fitted over their respective shanks **63** and the fasteners **60** are then inserted and retained in the retainer bodies **12** as was described above. After insertion, the fasteners are held snugly in their retainer bodies **12** so that they don't wobble as illustrated by arrow **W.** If the screw holes (not shown) that are to receive the threaded portions **69** have substantially the same spacing as **S**_{**c**} of **FIG. 12,** then the fasteners **60** will be substantially aligned with their respective screw holes because the fastener **60** don't wobble **W** after retention in the retainer bodies **12.**

In **FIG.15**, a heat sink **90** having a fan **99** mounted thereon is connected with the base plate **80** and a base portion **91** of the heat sink **90** is positioned in the aperture **81**. The threaded portions **69** can be easily aligned with their respective screw holes and the base plate **80** can be mounted to the mother board such that the base portion **91** is in contact with a surface of a component to be cooled by the heat sink **90**.

The retainer assembly **10** as described herein can be manufactured using a variety of methods. For instance, the retainer assembly **10** can be manufactured out of metal, an elastomer, rubber, or plastics using a process such as machining, casting, molding, and injection molding. An exemplary retainer assembly **10** was manufactured out of plastic using polycarbonate 30% glass filled material through an injection molding process.

Turning now to **FIGS. 9a** and **9b**, exemplary dimensions in millimeters (mm) for the fastener **60** and the spring **70** include but are not limited to those set forth below.

For the fastener **60: L** = 35.4 mm; **L**_{**1**} = 28.9mm +0.1/-0.15 mm; **L**_{**2**} = 21.9 mm; **L**_{**3**} = 5.5 mm; **L**_{**4**} = 1.0 mm; **L**_{**5**} = 3.0 mm; **H**_{**R**} = 8.0 mm and **D**_{**R**} = 3.50 mm; **D**_{**S**} = 5.0 mm +0.1/-0.0 mm; **D**_{**SO**} = 4.95 mm +0.1/-0.05 mm; and **D**_{**T**} is application specific; however, a 6-32 UNC threading was used for the threaded portion **69;** and a radiused portion **64** of the threaded portion **69** had a radius **R**_{**T**} = 0.20 mm.

For the spring **70:** a length **L**_{**S**} = 16.75 mm ± 0.1 mm; and an inside diameter **d**_{**s**} = 6.7 mm ± 0.15 mm.

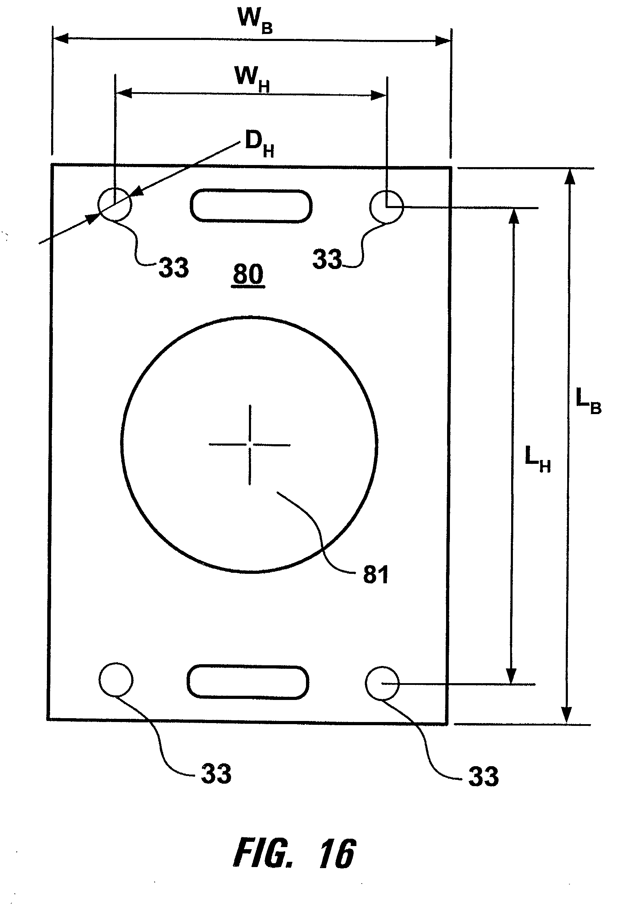

One example of an useful application of the retainer assembly **10** of the present invention is to retain a fastener or a fastener and a spring to a base plate that is connected with a cooling device such as a heat sink. In **FIG. 16**, an exemplary dimensions for the base plate **80** (in millimeters) include but are not limited to a length **L**_{**B**} = 89 mm ± 0.2 mm and a width **W**_{**B**} = 68.5 mm ± 0.2 mm. A center-to-center spacing between the bore holes **33** on the width dimension of the base plate **80** is **W**_{**H**} = 38 mm ± 0.15 mm and on the length dimension is **L**_{**H**} = 81 mm ± 0.15 mm. The bore holes **33** can have an inside diameter **D**_{**H**} = 6.6 mm to 7.0 mm.

An exemplary retainer assembly **10** (see **FIGS. 7, 8a,** and **8b**) can have dimensions (in millimeters) that include but are not limited to: the first inside diameter **D**_{**1**} = 5.1 mm; the third inside diameter **D**_{**3**} = 4.85 mm; the second inside diameter **D**_{**2**} varies from 5.1 mm to 4.85 mm at the slip-over profile **21** such that at the beginning of the slip-over profile, **D**_{**2**} = 5.1 mm and at the annular ring **23**, **D**_{**2**} = 4.85 mm; a distance between axes **Y-Y** of the retainer bodies **12** of **S**_{**R**} = 38 mm ± 0.05 mm; an overall height **H**_{**R**} = 8.05 mm; an overall length **L**_{**R**} = 45.5 mm; a thickness **T**_{**R**} = 1.8 mm; a width of the spanner 50 of **W**_{**R**} = 3 mm; a diameter of the retainer bodies **12** across the ribs **27** of **DR** = 7.43 ± 0.1 mm; an outside diameter **D** = 5.23 mm; and a thickness (i.e. the distance the ribs **27** extend outward of the outer wall **13)** of the ribs **27** = 1.2 mm.

The above listed dimensions for the fastener **60,** the spring **70,** the base plate **80**, and the retainer assembly **10** are example dimensions only and the present invention is not to be construed as being limited to those dimensions. Actual dimensions for the fastener **60,** the spring **70,** the base plate **80,** and the retainer assembly **10** will be application dependent. Moreover, although the retainer assembly **10** has been described as being useful as a fastener retainer for a base plate, the retainer assembly **10** is not to be construed as being limited to that use only. The retainer assembly **10** can be used in any application in which retention of a fastener or a fastener in addition to other elements including a spring is desirable.

Although several embodiments of the present invention have been disclosed and illustrated, the invention is not limited to the specific forms or arrangements of parts so described and illustrated. The invention is only limited by the claims.

## Claims

1. A retainer assembly **10** for retaining a fastener **60** including a shank **63** with a recessed portion **65**, comprising:
at least one retainer body **12** including:
an outer wall **13** having an outside diameter **D**; and
an inner wall **15** inset from the outer wall **13** and symmetrically positioned about an axis **Y-Y** and defining a chamber **20** through the retainer body **12** having an entrance aperture **17** positioned opposite an exit aperture **19,**
the inside wall **13** including a first inside diameter **D**_{**1**} extending inward of the entrance aperture **17** along the axis **Y-Y** and narrowing to a second inside diameter **D**_{**2**} at a slip-over profile **21** and narrowing again to a third inside diameter **D**_{**3**} at an annular ring **23** extending to the exit aperture **19,**
wherein in use the shank **63** is inserted through the entrance aperture **17** until the shank **63** engages and slips over the slip-over profile **21** and through the annular ring **23** so that the recessed portion **65** is captured within the annular ring **23** thereby retaining the fastener **60** in the chamber **20**.

2. A retainer assembly **10** as claimed in Claim 1 where in the retainer body **12** is made from an electrically non-conductive material, a metal, an elastomer, rubber, or plastic.

3. A retainer assembly **10** as claimed in Claim 2 where in the electrically non-conductive material is a glass filled polycarbonate.

4. A retainer assembly **10** as claimed in any preceding Claim further comprising a flange **25** connected with and extending outward of the outer wall **13** and operative to prevent complete insertion of the retainer body **12** into a bore **33** adapted to receive the retainer body **12**.

5. A retainer assembly **10** as claimed in any preceding claim, further comprising:
a plurality of ribs **27** connected with the outer wall **13** and extending outward therefrom, wherein the ribs **27** are adapted to deform when the retainer body **12** is inserted into a bore **33** adapted to receive the retainer body **12** so that the retainer body **12** is substantially centered in the bore 33 and is retained therein.

6. A retainer assembly **10** as claimed in Claim 5 wherein the ribs **27** are equidistantly spaced apart.

7. A retainer assembly **10** as claimed in Claim 5 wherein the ribs **27** have an orientation that is colinear with the axis **Y-Y**.

8. A retainer assembly **10** as claimed in any preceding claim further comprising:
at least two retainer bodies **12**,
a spanner **50** connected with said at least two retainer bodies **12** and operative to spatially position the retainer bodies **12** relative to each other.

9. A retainer assembly **10** as claimed in Claim 8 wherein the spanner 50 positions the retainer bodies **12** in a substantially planar orientation with each other.

10. A retainer assembly **10** as claimed in Claim 8 wherein the spanner **50** positions the retainer bodies **12** so that their respective axes **Y-Y** are substantially aligned with a central axis **C-C** of a bore **33** the retainer bodies **12** are to be inserted in.

11. A fastener **60** for being retained in a retainer assembly **10** as claimed any preceding claim.
